# EUROPEAN PATENT APPLICATION

(11) **EP 4 492 934 A1**
(43) Date of publication of application: **15.01.2025**
(21) Application number: 24163714.9
(22) Date of filing: 15.03.2024
(51) Int. Cl.: H05K 7/20, H01L 23/473

(54) **POWER CONVERSION DEVICE**

(30) Priority: 11.07.2023 KR 20230089755
(71) Applicant: HL Mando Corporation, Pyeongtaek-si, Gyeonggi-do 17962 (KR)
(72) Inventor: SONG, Sangyoun, 17962 Pyeongtaek-si, Gyeonggi-do (KR); PARK, Hyeonwoo, 17962 Pyeongtaek-si, Gyeonggi-do (KR)
(74) Representative: BCKIP Part mbB

(57) **Abstract**

A power conversion device is provided. The power conversion device includes a semiconductor module having a semiconductor device and a heat dissipation fin, and a flow path through which a coolant flows, allowing the coolant to flow at least at an area where the heat dissipation fin is positioned, wherein the flow path is configured to direct a flow of the coolant upward. Thereby, it is possible to enhance cooling efficiency, increase power conversion efficiency and performance, as well as the service life of internal elements, and reduce the risk of fire.

## Description

### CROSS-REFERENCE TO RELATED APPLICATION

This application claims priority from Korean Patent Application No. 10-2023-0089755, filed on July 11, 2023.

### TECHNICAL FIELD

The present invention relates to a power conversion device and, more specifically, to a power conversion device capable of enhancing cooling efficiency, increasing power conversion efficiency and performance, as well as the service life of internal elements, and reducing the risk of fire.

### BACKGROUND

An electric vehicle refers to a vehicle that uses electrical energy rather than fossil fuels, and related technologies are developing rapidly in response to the recent depletion of fossil fuels and the trend of developing eco-friendly vehicles.

Electric vehicles that use electricity as an energy source are essentially equipped with high-voltage batteries, and the high-voltage batteries supply the necessary power while repeatedly charging and discharging during driving. A power conversion device is provided to convert the high-voltage power supplied from the battery to a low voltage of the system used in the vehicle.

During the conversion of high-voltage, high electrical currents may be present, and the power conversion device assumes a high-temperature state, which may, in exceptional cases, even cause a fire. Thus, the heat dissipation performance of the power conversion device is important. Further, the heat dissipation performance of the power conversion device is of great significance because it affects not only the efficiency and performance of power conversion but also the lifespan of the device.

### BRIEF SUMMARY OF THE INVENTION

In view of the foregoing background, it is an object of the present invention to provide a power conversion device capable of enhancing cooling efficiency, increasing power conversion efficiency and performance, as well as the service life of internal elements, and reducing the risk of fire.

To this end, the present invention provides a power convers device in accordance with claim 1.

According to one aspect of the invention, there is provided a power conversion device, comprising a semiconductor module having a heat dissipation fin and a flow path through which a coolant flows, allowing the coolant to flow at least at an area where the heat dissipation fin is positioned, wherein the flow path is configured to direct a flow of the coolant upward.

It is one of the ideas of the present invention to direct a flow of coolant impacting on a heat dissipation fin in a power converter towards an upper end of the heat dissipation fin coupled to a semiconductor device of the heat dissipation fin and/or to direct the flow of coolant such that it impacts the heat dissipation fin in an upper part facing the semiconductor device. Thereby, a more uniform distribution of flow velocity may be achieved and heat exchange between the coolant and the heat dissipation fin may be improved.

According to a further aspect of the present invention, there may be provided a power conversion device, comprising a housing having a flow path through which a coolant flows, wherein the flow path includes a heat exchanger having an opening in an upper portion thereof, and wherein a guide portion obliquely protruding upward is formed on a lower surface of the flow path, a cover covering the upper portion of the heat exchanger, coupled to the housing, and having a communication hole communicating with the heat exchanger, and a semiconductor module coupled to the cover and having a heat dissipation fin inserted to the communication hole.

According to the present invention, it is possible to enhance cooling efficiency, increase power conversion efficiency and performance, as well as the service life of internal elements, and reduce the risk of fire.

### DESCRIPTION OF DRAWINGS

The above and other objects, features, and advantages of the invention will be more clearly understood from the following detailed description, taken in conjunction with the accompanying drawings, in which:
FIG. 1 is a perspective view illustrating a power conversion device according to an embodiment of the present invention;
FIG. 2 is an exploded perspective view illustrating a portion of the power conversion device according to an embodiment of the present invention;
FIG. 3 is a perspective view illustrating a portion of a power conversion device according to an embodiment of the present invention;
FIG. 4 is a cross-sectional view illustrating a portion of a power conversion device according to an embodiment of the present invention;
FIG. 5 is a cross-sectional view illustrating a portion of a power conversion device according to an embodiment of the present invention;
FIG. 6 is a cross-sectional view illustrating a portion of a power conversion device according to an embodiment of the present invention; and
FIG. 7A and FIG. 7B are views illustrating the cooling efficiency of a power conversion device according to an embodiment of the present invention.

### DETAILED DESCRIPTION OF EXEMPLARY EMBODIMENTS

In the following description of examples or embodiments of the invention, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the invention, detailed descriptions of well-known functions and components incorporated herein will be omitted when it is determined that the description may make the subject matter in some embodiments of the invention rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or " (B)" may be used herein to describe elements of the invention. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

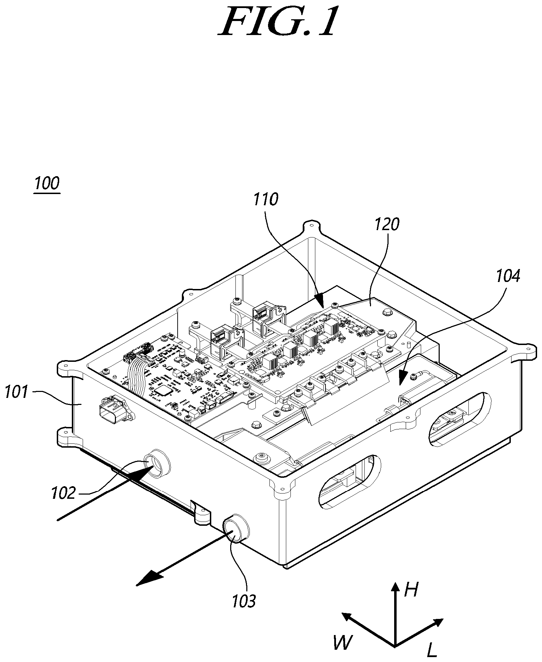

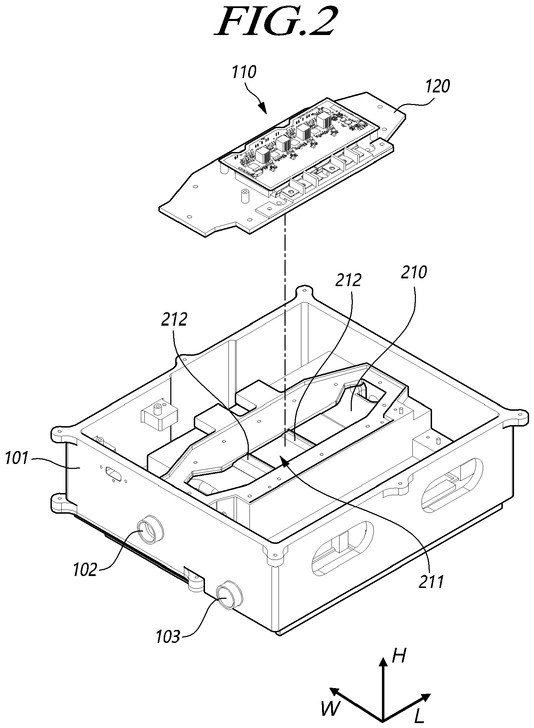

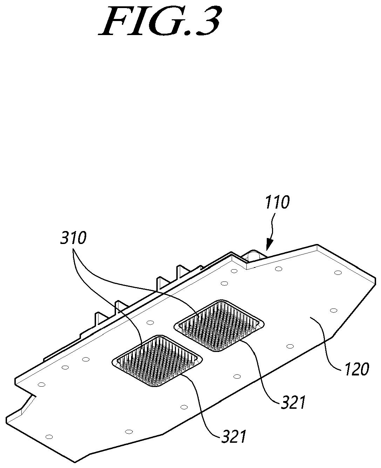

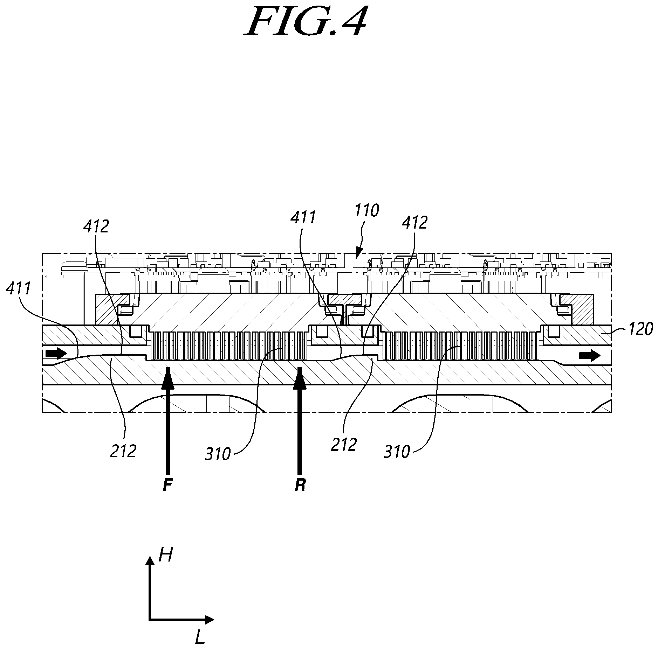

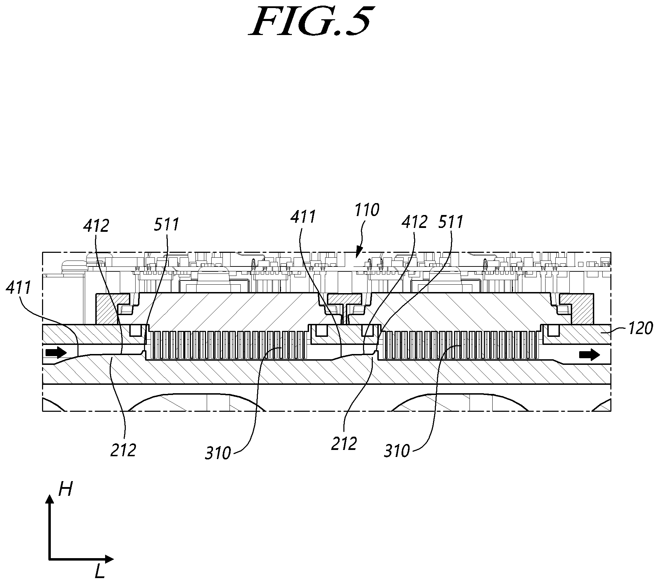

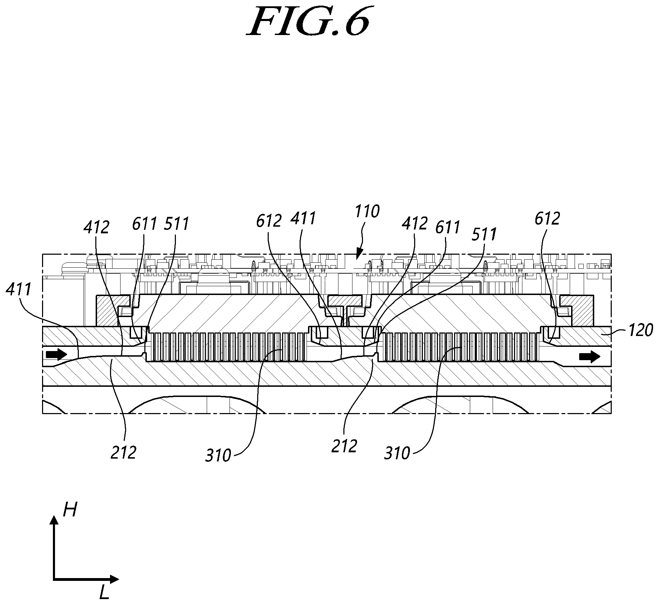

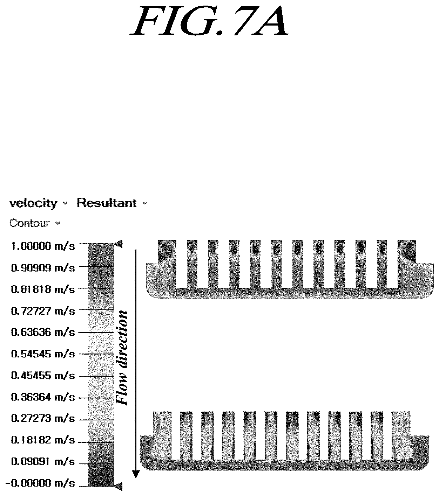

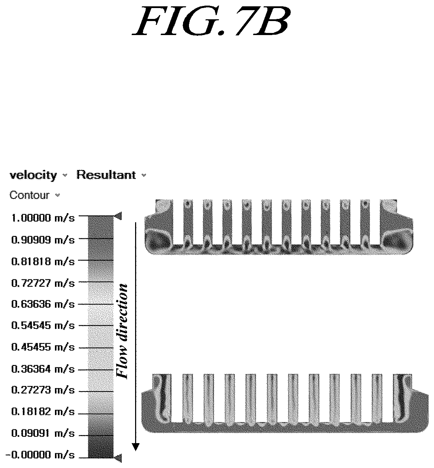

FIG. 1 is a perspective view illustrating a power conversion device. FIG. 2 is an exploded perspective view illustrating a portion of the power conversion device. FIG. 3 is a further perspective view illustrating a portion of the power conversion device. FIG. 4 is a cross-sectional view illustrating a portion of the power conversion device. FIG. 5 is a cross-sectional view illustrating a portion of a further power conversion device. FIG. 6 is a cross-sectional view illustrating a portion of a further power conversion device. FIG. 7A and FIG. 7B are views illustrating the cooling efficiency of the power conversion device.

The power conversion device 100 includes a semiconductor module 110 having a heat dissipation fin 310 and a flow path 210 through which a coolant flows. The flow path, generally, may be configured to allow the coolant to flow at least in an area where the heat dissipation fin 310 is positioned, wherein the flow path is configured to direct a flow of the coolant directed upward. The power conversion device 100, for example, may be a DC-DC converter.

Referring to FIGS. 1 to 3, the power conversion device 100 may include a housing 101 and electronic components accommodated inside the housing 101. The housing 101, for example, accommodates a semiconductor module 110. Additionally, a capacitor 104, and an inductor (not shown) may be positioned within the housing 101.

The semiconductor module 110 includes a semiconductor device and a heat dissipation fin 310. The semiconductor device of the semiconductor module 110 may be configured to convert a high-voltage current, which may, for example, be applied from a battery, into a low-voltage current. The energy converted by the semiconductor device may be stored as energy in the capacitor 104 and the inductor. For example, the semiconductor device may comprise a carrier, e.g., in the form of a PCB, on which electronic circuitry is mounted that is configured to convert an input DC-current from a first voltage level to an output DC-current of a second voltage level different from the first voltage level. Heat generated from the semiconductor device during power conversion is dissipated through the heat dissipation fin 310. Thereby, the semiconductor device is cooled. The semiconductor device may be, e.g., an SiC semiconductor device. The heat dissipation fin 310 protrudes from the semiconductor device, i.e., from a first side or surface of the semiconductor device. A first end of the heat dissipation fin 310 connected to the semiconductor device may be referred to as an upper end of the heat dissipation fin 310, and a second end of the heat dissipation fin 310 facing away from the semiconductor device may be referred to as a lower end of the heat dissipation fin 310. The semiconductor device and the heat dissipation fin 310 may constitute a single unit. In the power conversion device 100, a plurality of units, constituted by the semiconductor device and the heat dissipation fin 310, may be provided. In the drawings, a semiconductor module 110 having two semiconductor devices and two heat dissipation fins 310 is illustrated by way of example only. The present invention, however, is not limited to this example, and a greater or lower number of semiconductor devices and heat dissipation fins 310 may be provided.

A flow path 210 is formed in the housing 101 to cool electronic components received in the housing 101. For example, the housing 101 may include a channel that defines or forms the flow path 210. The flow path 210 may comprise a heat exchanger section 211 in which heat exchange between the heat dissipation fin 310 and a coolant takes place as will be explained in more detail below. The flow path 210 may extend at least section wise along a length direction L. In particular, the heat exchanger section 211 of the flow path 210 may extend in the longitudinal direction L. The housing 101 may comprise an inlet 102 through which coolant is introduced and an outlet 103 through which coolant is discharged. The inlet 102 and the outlet 103 may be formed at opposite ends of the flow path 210. The flow path 210 is formed to cool the semiconductor module 110 and, if provided, the optional capacitor 104 and the optional inductor provided in the housing 101.

The heat dissipation fin 310 of the semiconductor module 110 is disposed on or in the flow path 210. In particular, the heat dissipation fin 310 is positioned in the heat exchanger section 211 of the flow path 210. The heat dissipation fin 310 and the coolant flowing in the flow path 210 perform heat-exchange, e.g., through forced convection, to cool the semiconductor module 110. The flow path 210 is formed to have an upper opening in the housing 101. For example, the channel formed in the housing 101 may comprise an open part in which the channel is opened with respect to a height direction H extending transverse to the longitudinal direction L. The upper opening of the flow path 210 may be formed in the heat exchanger section 211 where the semiconductor module 110 is cooled. For example, as schematically shown in FIG. 4, the heat dissipation fin 310 may protrude into the heat exchanger section 211 in the height direction, and the lower end of the heat dissipation fin 310 may face a bottom of the channel.

The semiconductor module 110 may be coupled to a cover 120, wherein the semiconductor device may be positioned at an upper side of a cover 120 facing away from the flow path 210 in the height direction H. The cover 120 covers the heat exchanger section 211 of the flow path 210. The cover 120 has a communication hole 321, and the heat dissipation fin 310 protrudes from the semiconductor device in the height direction H through the communication hole 321, so that it protrudes from a lower side of the cover 120 facing the channel, i.e., the bottom of the channel. When a plurality of semiconductor devices and a plurality of heat dissipation fins 310 are provided, a corresponding number of communication holes 321 may be provided to accommodate each of them. The heat dissipation fin 310 is positioned to exchange heat with the coolant in the flow path 210 when the cover 120 is coupled to the housing 101, covering the heat exchanger 211.

The flow path 210 is formed to direct the flow of the coolant supplied to an upper side of the heat dissipation fin 310 and/or such that the flow of coolant impacts the heat dissipation fin 310 between the upper and the lower end, preferably closer to the upper end. The cover 120 is coupled to the housing 101 in a manner that it covers the heat exchanger second 211 from above with respect to the height direction. The heat dissipation fin 310 is provided to protrude downward of the cover 120 in the height direction H. The flow path 210 is configured such that the coolant supplied from the flow path 210 to the heat dissipation fin 310 is directed to an upper side of the heat dissipation fin 310. The coolant is introduced into the flow path 210 through the inlet 102 and flow in the flow path 210 in a flow direction. That is, the coolant travels along the direction in which the flow path is formed (i.e., the length direction L). The coolant is introduced into the heat exchanger section 211 through a heat exchanger inlet, and discharged from the heat exchanger section 211 through a heat exchanger outlet. The heat exchanger inlet and the heat exchanger outlet may define a length of the heat exchanger section in the longitudinal direction. The flow path 210 is configured such that the coolant introduced into the heat exchanger section is directed upward in the heat exchanger 211 toward the heat dissipation fin 310, specifically, towards the upper end of the heat dissipation fin 310 coupled to the semiconductor device. Accordingly, the efficiency of heat exchange with the heat dissipation fin 310 is enhanced, leading to higher cooling performance.

FIG. 7A illustrates the flow velocity of the coolant along the flow direction in a conventional power conversion device. FIG. 7B illustrates the flow velocity of the coolant exchanged with the heat dissipation fin 310, along the flow direction, in the power conversion device 100 according to the present invention.

The conventional power conversion device has a simple structure in which a heat dissipation fin is provided in the flow path. The difference in flow resistance caused by the presence of the heat dissipation fin leads to non-uniformity in which the flow velocity is higher around the lower end of the heat dissipation fin while the flow velocity is lower around the upper end of the heat dissipation fin. Such flow velocity non-uniformity primarily occurs from a front portion (see reference character F in FIG. 4) of the heat dissipation fin to a rear portion (see reference character R in FIG. 4) of the heat dissipation fin along the flow direction of the coolant (i.e., along the length direction L), causing deterioration of cooling efficiency. In the length direction L, a direction from the inlet 102 towards the heat dissipation fin 310 may be referred to as a rearward direction and a direction opposite to the rearward direction may be referred to as a forward direction.

The power conversion device 100 as described herein, is designed such that the flow of the coolant supplied to the heat dissipation fin 310 is directed upward and/or applied to the heat dissipation fin 310 in an upper end portion. This arrangement ensures uniform flow around the upper end and lower ends of the heat dissipation fin 310 and thus enhances cooling efficiency. Comparison between FIG. 7A and FIG. 7B reveals that the flow velocity from the upper end to the lower end of the heat dissipation fin is uniformly distributed as the coolant is provided toward the upper end of the heat dissipation fin, e.g., by way of a guide portion 212 as shown in FIGS. 4 to 6. It may be identified that the uniformity of flow velocity from the front portion to the rear portion of the heat dissipation fin is also enhanced. Accordingly, the power conversion device may enhance cooling efficiency and increase the power conversion efficiency and performance of the semiconductor device. By enhancing cooling performance, it is also possible to prevent deterioration of lifespan of the semiconductor device, increase the lifespan, and reduce the risk of fire.

The shape of the flow path of the power conversion device 100 is described in greater detail with reference to FIGS. 4 to 6.

Referring to FIG. 4, a guide portion 212 may be provided in the flow path 210. The guide portion 212 may be formed positioned in front of the heat dissipation fin 310 with respect to the flow direction of coolant. That is, generally, the guide portion 212 may be formed at a position between the inlet 102 and the heat exchanger inlet. The guide portion 212 may end at the heat exchanger inlet. For example, the guide portion 212 may comprise a discharge end being placed at of forming the heat exchanger inlet. The guide portion 212 may be formed on a lower surface or bottom surface of the channel facing the cover 120, as exemplarily shown in FIG. 4. Generally, the guide portion may extend at least partially protrude obliquely upward from the lower surface of the heat exchanger 211. Hence, the guide portion 212 extends obliquely towards the semiconductor device. The guide portion 212 protrudes in the height direction H from the lower surface of the flow path 210 by a predefined height that increases along the flow direction of the coolant (i.e., along the rearward direction) or with decreasing distance to the heat exchanger inlet. Accordingly, the guide portion 212 causes the coolant flowing in the flow path 210 to have flow direction component upward or towards the upper end of the heat dissipation fin 310 along the height direction H. As shown in the drawings, the guide portion 212 is positioned in front of the heat dissipation fin 310 with respect to the flow direction, directing the flow of coolant upward. The coolant, caused to have a flow direction component upward by the guide portion 212, is provided to the heat dissipation fin 310.

In the case of multiple heat dissipation fins 310, the guide portion 212 may be provided at a position corresponding to each heat dissipation fin 310. When a plurality of guide portions 212 are provided, the coolant supplied to the heat exchanger 211 is given flow directivity upward by the first guide portion, cools the first heat dissipation fin, and is then sequentially given flow directivity upward by the subsequent guide portions to cool the subsequent heat dissipation fins.

Optionally, the upper end of the guide portion 212 may be positioned above the lower end of the heat dissipation fin 310. In other words, with respect to the lower surface of the flow path 210, the height of the guide portion 212 protruding obliquely upward in the height direction H may be positioned above (i. e., may be positioned higher than) the lower end of the heat dissipation fin 310. That is, the discharge end of the guide portion 212, with respect to the height direction H, may positioned closer to the semiconductor device than a lower end of the heat dissipation fin 310. Accordingly, the coolant given flow directivity upward while being guided by the guide portion 212 is first provided to an upper part of the heat dissipation fin 310. Since the upper part of the heat dissipation fin 310 has higher flow resistance than the lower part thereof, it is possible to further enhance flow velocity uniformity by first supplying the coolant to the upper part of the heat dissipation fin 310.

As exemplarily shown in FIGS. 4 to 6, the guide portion 212 may optionally include an inclined portion 411 inclined upward and a flat portion 412 horizontally extending from the upper end of the inclined portion 411. The inclined portion 411 may protrude upward from the lower surface of the flow path 210 while having a gentle inclination. Generally, the inclined portion 411 is inclined relative to the longitudinal direction between a lower end and an upper end which is positioned closer to the semiconductor device in the height direction than the lower end. The lower end may be positioned at the level of the lower surface of the channel, as exemplary show in FIGS. 4 to 6. The flat portion 412 may horizontally extend toward the rearward direction from the upper end where the inclination of the inclined portion 411 ends. In other words, the flat portion 412 may extend parallel to the longitudinal direction between the upper end of the inclined portion 411 and the heat exchanger inlet. By the inclination of the inclined portion 411, a cross-section of the flow path 210 in the height direction H decreases, and flow velocity increases. The coolant with the increased flow velocity flows along the portion where the flat portion 412 is formed while being supplied to the upper end of the heat dissipation fin 310. The inclined portion 411 may, for example, be shaped as a convex curved surface. The inclined portion 411 may be formed to have a convex curved surface to facilitate upward flow direction of the coolant, and the upper end of the inclined portion 411 is smoothly and seamlessly connected to the flat portion 412.

As exemplarily shown in FIG. 5, the guide portion 212 may optionally include a stepped portion 511 protruding upward in the height direction, i.e . , towards the cover or the semiconductor device, from the rear end of the flat portion 412. The stepped portion 511, thus, is positioned at the discharge end of the guide portion 212. The stepped portion 511 protrudes from the rear end of the flat portion 412 and increases the upward flow directivity imparted to the coolant by the inclined portion 411. In other words, the coolant flowing along the flat portion 412 is directed upwards one more time at the rear end of the flat portion 412 by the stepped portion 511 and is then immediately supplied to the heat dissipation fin 310. Accordingly, cooling efficiency may further be increased.

The stepped portion 511 may, for example, extended in a widthwise direction W from a first widthwise end of the flat portion 412 to an opposite second widthwise end . Optionally, the stepped portion 511 protrudes from the flat portion 412 by a predefined height which may be constant in the widthwise direction. In other words, the height of the stepped portion 511 along the width direction W may be constant. It should be noted that the protruding height of the stepped portion 511 should be formed not to impede the flow of the coolant, and is preferably smaller than the height of the inclined portion 411. The entire coolant flowing in the flow path 210 is uniformly directed upward by the stepped portion 511, thereby making it possible to suppress formation of an eddy that could otherwise lead to a decrease in cooling efficiency.

The stepped portion 511, in particular, at a front surface thereof, may be connected to the flat portion 412 through a curved surface. The curved surface at the front of the stepped portion 511 may be a convex curved surface or a concave curved surface. In other words, the stepped portion 511 may protrude with an incline connected to the rear end of the flat portion 412, and the front surface of the incline connected to the flat portion 412 may be shaped as a concave surface. As the front surface of the stepped portion 511 is shaped as a concave surface, the acceleration of the upward flow directivity by the stepped portion 511 may be maximized although the stepped portion 511 has a smaller height.

As exemplarily shown in FIG. 6, optionally, a first inclined surface 611 may be formed at a lower surface of the cover 120 facing the flow path 210, in particular, the channel. The first inclined surface 611 helps to minimize flow resistance acting on the coolant caused by the stepped portion 511. In other words, the first inclined surface 611 may be formed in the lower surface of the cover 120 and has an inclination upward in the flow direction (i.e., the rearward direction). The first inclined surface 611 may be positioned ahead of the communication hole 321 in the flow direction, that is, on a side of the communication hole 321 that faces towards the heat exchanger inlet with respect to the longitudinal direction L. The first inclined surface 611 is inclined such that a distance in the height direction between the first inclined surface and the semiconductor device decreases with decreasing distance between the first inclined surface 611 and the communication hole 321 in the longitudinal direction. The first inclined surface 611 may be connected to the communication hole 321. The first inclined surface 611 may be positioned corresponding to the stepped portion 511 with respect to the longitudinal direction L, as exemplarily shown in FIG. 6. Therefore, when upward flow directivity is given to the coolant one more time by the stepped portion 511, it becomes possible to remain a cross-sectional area of the flow path 210 substantially constant by having the first inclined surface 611, thereby reducing fluid dynamical losses. The cross-sectional area that is remained in the manner means a cross-sectional area of the flow path 210 when the flow path 210 is viewed in the length direction L.

Additionally or alternatively, the cover 120 may have a second inclined surface 612 which is provided to further reduce fluid dynamical losses of the coolant after heat exchange with the heat dissipation fin 310. The second inclined surface 612 may be formed in the lower surface of the cover 120 and has an inclination downward in the flow direction (i.e., the rearward direction). The second inclined surface 612 may be positioned behind the communication hole 321 in the flow direction, that is, on a side of the communication hole 321 that faces away from or is opposite to the heat exchanger inlet with respect to the longitudinal direction L. The second inclined surface 612 has an inclination downward in the flow direction. That is, it is inclined such that a distance in the height direction between the second inclined surface 612 and the semiconductor device increase with increasing distance between the first inclined surface 611 and the communication hole 321 in the longitudinal direction. The second inclined surface 612 may connected to the communication hole 321. By providing a flow space for the coolant, via the second inclined surface 612, at the rear of the upper end of the heat dissipation fin 310, where flow resistance is higher, flow resistance for the coolant after exchanging heat with the heat dissipation fin 310 may be further reduced.

The present invention may also be realized according to the following embodiments:
A power conversion device 100 according to some embodiments may include a housing 101 having a flow path 210 to which a coolant is introduced, wherein the flow path 210 includes a heat exchanger 211 having an opening in an upper portion thereof, and wherein a guide portion 212 obliquely protruding upward is formed on a lower surface of the heat exchanger 211, a cover 120 covering the upper portion of the heat exchanger 211, coupled to the housing 101, and having a communication hole 321 communicating with the heat exchanger 211, and a semiconductor module 110 coupled to the cover 120 and having a heat dissipation fin 310 inserted to the communication hole 321. With reference to FIGS. 1 to 7, the same matters as those in the above-described embodiments are briefly described using the same reference numerals.

According to an embodiment, the heat dissipation fin 310 may be positioned behind (i.e., at a rear side) the guide portion 212 in the heat exchanger 211. The heat dissipation fin 310 is inserted to the communication hole 321 in the downward direction and positioned on the flow path 210. The heat dissipation fin 310 is positioned behind the guide portion 212 to receive the coolant directed upward by the guide portion 212.

According to an embodiment, the upper end of the guide portion 212 may be positioned at a higher position than the lower end of the heat dissipation fin 310.

According to an embodiment, the guide portion 212 may include an inclined portion 411 inclined upward toward the flow direction (i.e., toward the rearward direction) and a flat portion 412 horizontally extending from the upper end of the inclined portion 411.

According to an embodiment, the inclined portion 411 may be shaped as a convex surface.

According to an embodiment, the guide portion 212 may include a stepped portion 511 protruding upward from the rear end of the flat portion 412.

According to an embodiment, the stepped portion 511 may be formed from a widthwise end of the flat portion 412 to the other widthwise end.

According to an embodiment, the stepped portion 511 may have a constant height along the width direction W.

According to an embodiment, the front surface of the stepped portion 511 may be connected to the flat portion 412 through a curved surface. The curved surface at the front of the stepped portion 511 may be a convex curved surface or a concave curved surface.

According to an embodiment, the first inclined surface 611 may be formed in the lower surface of the cover 120 at a position ahead of the communication hole 321. The first inclined surface 611 has an inclination upward in the flow direction (i.e., the rearward direction).

According to an embodiment, the second inclined surface 612 may be formed in the lower surface of the cover at a position behind the communication hole 321. The second inclined surface 612 has an inclination downward in the flow direction (i.e., the rearward direction).

By the so-shaped power conversion device, it is possible to enhance cooling efficiency, increase power conversion efficiency and performance, as well as the service life of internal elements, and reduce the risk of fire.

The above-described embodiments are merely examples, and it will be appreciated by one of ordinary skill in the art various changes may be made thereto without departing from the scope of the invention. Accordingly, the embodiments set forth herein are provided for illustrative purposes, but not to limit the scope of the invention, and it should be appreciated that the scope of the invention is not limited by the embodiments. The scope of the invention should be construed by the following claims, and all technical spirits within equivalents thereof should be interpreted to belong to the scope of the invention. Also, it is noted that any one feature of an embodiment of the present invention described in the specification may be applied to another embodiment of the present invention. Similarly, the present invention encompasses any embodiment that combines features of one embodiment and features of another embodiment.

## Claims

1. A power conversion device (100), comprising:
a semiconductor module (110) comprising a semiconductor device and a heat dissipation fin (310) protruding from the semiconductor device in a height direction (H); and
a flow path (210) for passing a coolant,
wherein the flow path (210) comprises a heat exchanger section (211) extending in a longitudinal direction (L), and the heat dissipation fin (310) at least partially is positioned in the heat exchanger section (211),
wherein the flow path (210) is configured to direct the coolant into the heat exchanger section (211) through a heat exchanger inlet such that it comprises a flow direction component along the height direction (H) towards the semiconductor device, and/or wherein the heat dissipation fin extends beyond the heat exchanger inlet in the height direction (H).

2. The power conversion device (100) of claim 1, wherein a guide portion (212) is formed in the flow path (210) at a position between an inlet (102) of the flow path (210) and the heat exchanger inlet, wherein the guide portion (212) ends at the heat exchanger inlet and, at least partially, extends obliquely towards the semiconductor device.

3. The power conversion device (100) of claim 2, wherein the guide portion (212) comprises a discharge end arranged at the heat exchanger inlet, wherein the discharge end, with respect to the height direction, is positioned closer to the semiconductor device than a lower end of the heat dissipation fin (310) facing away from the semiconductor device.

4. The power conversion device (100) of claim 2 or 3, wherein the guide portion (212) includes an inclined portion (411) extending inclined relative to the longitudinal direction between a lower end and an upper end which is positioned closer to the semiconductor device in the height direction than the lower end, and a flat portion (412) extending in the longitudinal direction from an upper end of the inclined portion (411).

5. The power conversion device (100) of claim 4, wherein the inclined portion (411) is formed as a convex curved surface.

6. The power conversion device (100) of claim 4 or 5, wherein the guide portion (212) includes a stepped portion (511) positioned on an end of the flat portion (412) adjacent to the heat exchanger inlet, the stepped portion (511) protruding from the flat portion (412) in the height direction towards the semiconductor device.

7. The power conversion device (100) of claim 6, wherein the stepped portion (511) is formed extending in a width direction from a first widthwise end of the flat portion (412) to an opposite second widthwise end of the flat portion (412).

8. The power conversion device (100) of claim 7, wherein the stepped portion (511) over its expanse in the width direction has a constant height in the height direction.

9. The power conversion device (100) of any one of claims 6 to 8, wherein the stepped portion (511) is connected to the flat portion (412) through a concave surface.

10. The power conversion device (100) of any one of the preceding claims, further comprising:
a housing (101) accommodating the semiconductor module (110) and comprising a channel that defines the flow path (210), wherein the channel is open in the height direction at least in the heat exchanger section (211) of the flow path (210);
a cover (120) covering the open portion of the channel and being coupled to the housing (101), the cover (120) comprising a communication hole (321) communicating with the heat exchanger (211),
wherein the semiconductor module (110) is coupled to the cover (120), and the heat dissipation fin (310) protrudes through communication hole (321).

11. The power conversion device (100) of claim 10, wherein a first inclined surface (611) is formed on a lower surface of the cover (120) facing the channel, wherein the first inclined surface (611) is positioned on a side of the communication hole (321) facing the heat exchanger inlet in the longitudinal direction, and wherein the first inclined surface (611) is inclined towards the semiconductor device with decreasing distance to the communication hole (321) in the longitudinal direction.

12. The power conversion device (100) of claim 10 or 11, wherein a second inclined surface (612) is formed on a lower surface of the cover (120) facing the channel, wherein the second inclined surface (612) is positioned on a side of the communication hole (321) facing away from the heat exchanger inlet in the longitudinal direction, and wherein the second inclined surface (612) is inclined away from the semiconductor device with increasing distance from the communication hole (321) in the longitudinal direction.

13. The power conversion device (100) of anyone of the preceding claims, wherein the heat dissipation fin (310) is positioned adjacent to the heat exchanger inlet in the longitudinal direction (L).
